Europäisches Patentamt

European Patent Office

Office européen des brevets

(11) Publication number: **0 490 833 A1**

## EUROPEAN PATENT APPLICATION

(21) Application number: **91830532.7**

(22) Date of filing: **03.12.91**

(51) Int. Cl.5: **B60S 1/38**

(30) Priority: **07.12.90 IT 6798190**

(43) Date of publication of application:
**17.06.92 Bulletin  92/25**

(84) Designated Contracting States:
**BE DE ES FR GB**

(71) Applicant: **CHAMPION SPARK PLUG DIVISIONE COMPONENTISTICA AUTO DELLA COOPER INDUSTRIES ITALIA S.p.a.
Via Venaria 13**
**I-10040 Druento, Torino(IT)**

(72) Inventor: **Scorsiroli, Marcello
Via Filadelfia 204/C
I-10137 Torino(IT)**

(74) Representative: **Buzzi, Franco et al
c/o Jacobacci-Casetta & Perani S.p.A. Via Alfieri, 17
I-10121 Torino(IT)**

(54) Wiper arm for vehicle windscreen wipers.

(57) A wiper arm (1) for vehicle windscreen wipers has an arm structure (2) with claw means (7, 10, 11) for releasably holding a wiper blade (12) of elastomeric material. The wiper blade (12) is freely slidable longitudinally of the claw means (7, 10, 11) and the retaining claws (11) at the proximal end of the wiper blade (12) are associated with a first abutment (15) which prevents the sliding movement of the blade in a first direction. The retaining claws (7) corresponding to the distal end of the wiper blade (12) are associated with a second abutment (16) movable between an operative position and an inoperative position in which it respectively prevents and allows the sliding movement of the wiper blade (12) in a second direction opposite the first.

FIG. 1

The present invention generally relates to windscreen wipers for vehicles and more particularly to a wiper arm having retaining claws and a wiper blade of elastomeric or similar material having a longitudinal root portion releasably supported, at least at its proximal and distal ends, by the said retaining claws of the arm structure.

The wiper arms of the invention offer the advantage of greater structural simplicity and compactness over conventional windscreen wiper assemblies which consist of a spatulate member carrying the wiper blade and are pivotably and releasably connected to a control arm. Such wiper arms still have the problem of allowing easy removal of the wiper blade when replacement is necessary, yet of ensuring correct retention and centring of the blade when the windscreen wiper is in use.

In commercially available wiper arms, this problem is resolved by providing the retaining claws with oppositely disposed projections which fit into corresponding seats formed in the root part of the wiper blade. This arrangement, which prevents the wiper blade from being pulled out except when it is intentionally withdrawn at its distal end (that is, the end disposed towards the free end of the wiper arm) so that it can in fact be removed and replaced, entails the need to form the wiper blade by a moulding process. Obviously, this need is derived from the fact that only by moulding is it possible to produce on the root part of the wiper blade the seatings for engagement of the retaining claws of the arm.

For reasons of economy and simplicity of production, however, it would be desirable to be able to produce the wiper blade by continuous extrusion followed by guillotining, this is nevertheless in contrast to the aforesaid requirement.

The object of the present invention is to overcome the above-mentioned disadvantages and to produce a wiper arm of the above-defined type which makes it possible to reconcile the need for stable retention of the wiper blade on the one hand and easy removal thereof in case of need on the other, with the use of a wiper blade which does not call for any particular shape characteristics and which can therefore be produced by extrusion.

According to the invention, this object is achieved by virtue of the fact that:

- the wiper blade is freely slidable longitudinally of the said retaining means of the arm structure,
- a first abutment is associated with the retaining claws at the proximal end of the wiper blade to prevent the blade from sliding in a first direction,
- a second abutment is associated with the retaining claws at the distal end of the wiper blade and is movable between an operative position and an inoperative position in which it respectively prevents and allows sliding of the said wiper blade in a second direction opposite the first.

Thanks to this solution, it is no longer necessary to provide particular configurations of the retaining claws and wiper blade to prevent relative sliding. Moreover, it is easier not only to remove the wiper blade for replacement but also for the wiper-arm manufacturer to fit the blade in the first place, even in a fully mechanised and automated manner.

According to a preferred characteristic of the invention, the aforesaid second abutment is advantageously constituted by an end portion of the arm structure which pivots relative to the arm structure between a folded-down position corresponding to the operative position and a raised position corresponding to the inoperative position.

Conveniently, resilient means are associated with the end abutment portion for positioning and retaining it in the folded-down position.

Some examples of embodiments of the invention will now be described with reference to the appended drawings which are given by way of non-limiting example and in which:

Figure 1     is a partially sectional perspective view of a wiper arm for vehicle windscreen wiper devices according to the invention,

Figure 2     is an exploded perspective view on an enlarged scale showing the detail indicated by the arrow II in Figure 1,

Figure 3     is a lateral elevational view on an enlarged scale of the detail in Figure 2, shown in a first configuration,

Figure 4     is a view similar to Figure 3 but in a second configuration,

Figure 5     shows a first alternative to Figure 2,

Figure 6     is a lateral elevational view of an alternative embodiment in Figure 5,

Figure 7     is a cross-section taken on the line VII-VII in Figure 6,

Figure 8     shows a second alternative embodiment of Figure 2,

Figure 9     is a lateral elevation of the alternative embodiment in Figure 8 and

Figure 10     is a cross-section taken on the line X-X in Figure 9.

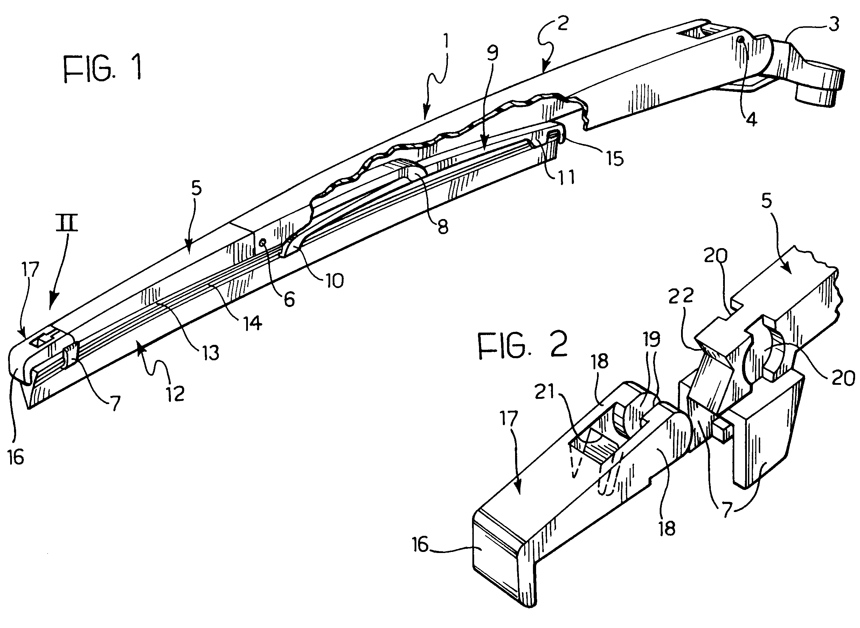

With reference initially to Figure 1, reference numeral 1 generally denotes a wiper arm for the windscreen wipers of vehicles, comprising essentially an arm structure 2 and a mounting 3 for attachment to a motor-driven operating shaft, both normally being of moulded plastics material and pivoted about a transverse pin 4.

The arm structure 2 has at its end opposite the mounting 3 a substantially arcuate element 5 pivotable about a transverse pin 6, also normally of plastics material, and of which the ends form outer 7 and inner 8 retaining claws respectively. The inner claws 8 support in a pivotable manner a second arcuate element 9 which is also of moulded plastics material and whose own ends form retaining claws 10, 11.

A wiper blade 12 of elastomeric material which in a manner known per se is formed with a root part 13 incorporating a resilient reinforcing member in the form of a thin longitudinal metal strip 14.

The root part 12 is supported by the arm structure 2 by means of the claws 7, 10 and 11, respectively close to its distal end (that is, the end facing the free end of the arm structure 2), in correspondence with its median zone and close to its proximal end (that is, the end facing the mounting 3).

Engagement between the claws 7, 10, 11 and the root part 13 of the wiper blade 12 is such that the latter is freely slidable in a longitudinal direction so that it can be easily pulled out of the arm structure 2 should it be necessary to remove it for possible replacement.

To ensure correct positioning and centring of the wiper blade 12 in relation to the claws 7, 10 and 11 when the wiper arm 1 is in use, two abutment teeth 15, 16 are provided which frontally face the proximal and distal ends of the blade 12 respectively.

The first abutment 15 is integral with the end of the arcuate element 9 which faces the mounting and is therefore fixed.

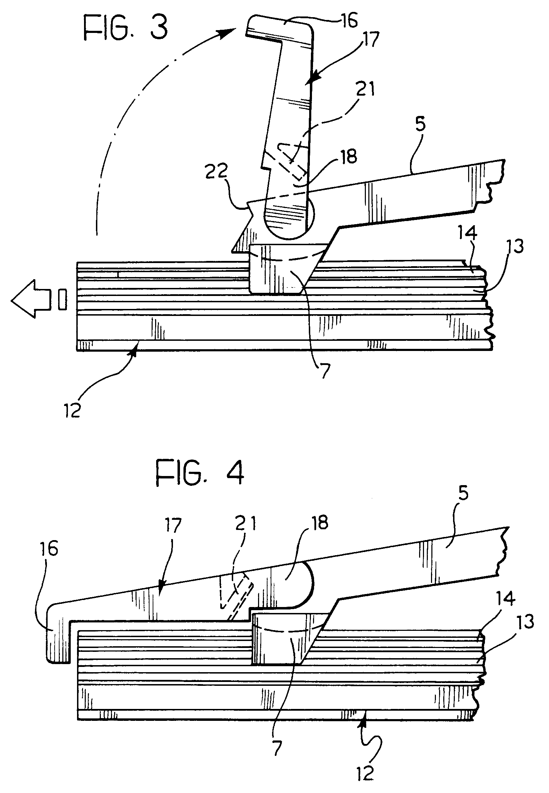

On the other hand, the second abutment 16 is movable between an operative position shown in Figures 1 and 2, in which it prevents the wiper blade 12 from being pulled out of the arm structure 2, and an inoperative raised position shown in Figure 3, in which it allows such pulling and therefore removal of the wiper blade 12.

As illustrated in greater detail in Figure 2, the abutment 16 is constituted by an appendage integral with an end of a terminal element 17, also of moulded plastics material, which is pivoted about a transverse axis at the end of the arcuate element 5 corresponding to the claws 7 so that it can rotate between the aforesaid folded-down and raised positions. The end of the terminal portion 17 opposite the abutment 16 is formed with two lateral longitudinal branches 18 carrying two oppositely disposed cylindrical projections 19 which rotatably engage two corresponding and matching lateral seats 20 formed on the sides of the arcuate element 5, at the claws 7. The terminal portion 17 is also formed, between the two arms 18, with a central resilient anchoring tongue 21 which is directed upwardly and cooperates with a frontal abutment 22 formed at the free end of the arcuate element 5. The resilient tongue 21 and the abutment 22 constitute a resilient system for positioning and retaining the end portion 17, and hence the abutment 16, in the folded-down position: in fact, following rotation of the end portion 17 from the raised position of Figure 3 to the folded-down position of Figures 1 and 2, the resilient tongue 21 snap-engages beneath the abutment 22 and the terminal portion 17 is therefore maintained in the folded-down position and can only be turned back into the raised position intentionally by a resilient deformation of the tongue 21.

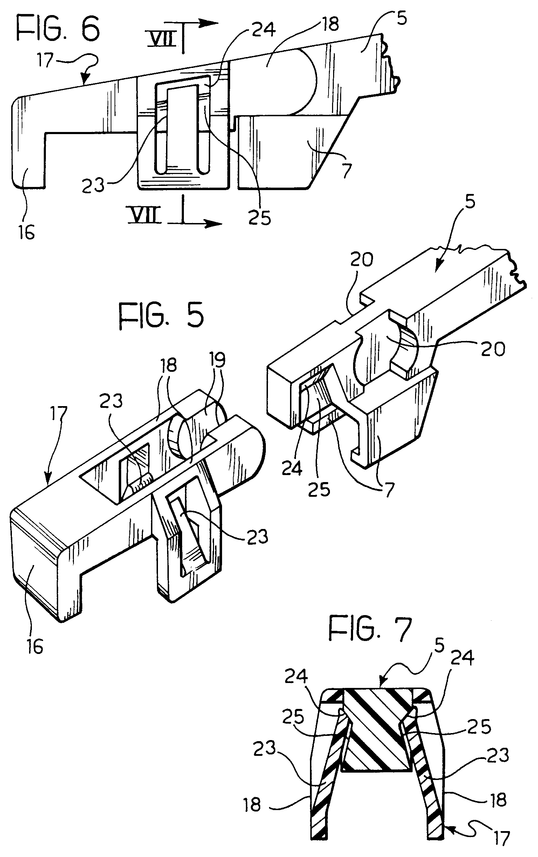

The alternative embodiments in Figures 5 to 7 and 8 to 10 are generally similar to the embodiment described above and only the differences will be described in detail, employing the same reference numbers for identical or similar parts. Both alternative embodiments relate to the resilient system for positioning and retaining the terminal portion 17, and hence the abutment 16, in the folded-down operative position.

In the case of Figures 5 to 7, the central tongue 21 is replaced by two lateral resilient tongues 23 formed integrally on the outsides of the longitudinal arms 18, at right-angles thereto, and corresponding snap-engagable lateral abutments 24 formed on the sides of the arcuate element 5 corresponding to two recesses 25.

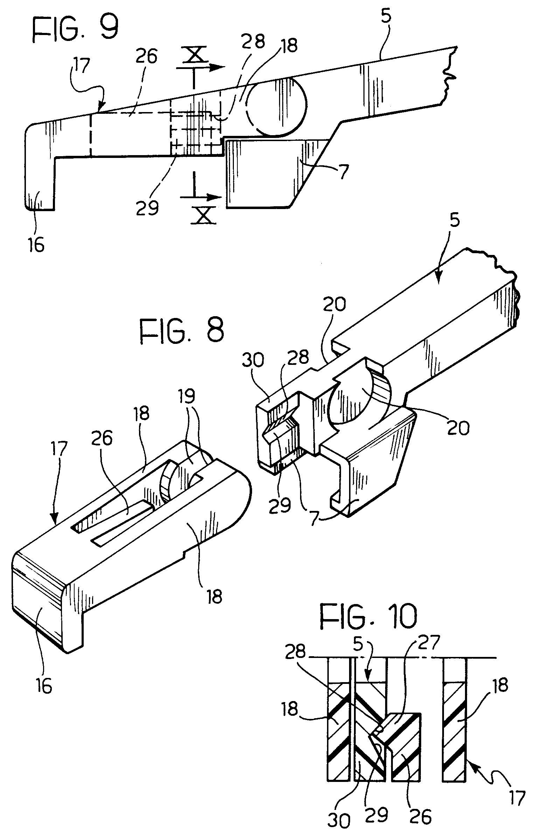

In the case of Figures 8 to 10, the tongue 21 is replaced by a longitudinal tongue 26 extending between the two arms 18, parallel therewith, and having a lateral projection 27 (Figure 10) which engages an abutment 28 defined by a longitudinal channel 29 formed in a lateral longitudinal appendage 30 of the arcuate element 5.

In both alternative embodiments, the pivoting between the terminal portion 17 and the arcuate element 5 is similar to that described with reference to the embodiment shown in Figures 1 to 4.

Naturally, the details of construction and the forms of actuation may vary widely from those which have been described and illustrated without thereby departing from the scope of the present invention.

## Claims

1. A wiper arm (1) for vehicle windscreen wipers, comprising an arm structure (2) with retaining claws (7, 10, 11) and a wiper blade (12) of elastomeric or similar material having a longitudinal root part (13) supported releasably, at least at its proximal and distal ends, by the retaining claws (7, 11) of the arm structure (2), characterised in that:

- the wiper blade (12) freely slidable longitudinally of the retaining claws (7, 10, 11),
- a first abutment (15) is associated with the retaining claws (11) at the proximal end of the wiper blade (12) to prevent the blade from sliding in a first direction,
- a second abutment (16) is associated with the retaining claws (7) at the distal end of the wiper blade (12) and is movable between an operative position and an inoperative position in which it respectively prevents and allows sliding movement of the wiper blade (12) in a second direction opposite the first.

2. A wiper arm according to Claim 1, characterised in that the second abutment (16) is carried by a terminal portion (17) of the arm structure (2) pivotable relative to the arm structure between a folded-down position corresponding to the said operative position and a raised position corresponding to the said inoperative position.

3. A wiper arm according to Claim 2, characterised in that resilient positioning and retaining means (21, 22, 23, 24, 26, 27, 28) are associated with the terminal portion (17) for maintaining it in the folded-down position.

4. A wiper arm according to Claim 2, characterised in that the terminal portion consists of a body (17) carrying at one end a toothed appendage (16) which cooperates frontally with the distal end of the wiper blade (12) and constitutes the second abutment, and carrying at the opposite end two opposing lateral cylindrical projections (19) which are pivotably engaged in two corresponding complementary lateral seats (20) formed in the arm structure (5).

5. A wiper arm according to Claim 3, characterised in that the resilient positioning and retaining means comprise a central, resilient anchoring tongue (21) carried by the terminal portion (17) and a frontal abutment (22) carried by the arm structure (5) and snap-engagable with the anchoring tongue (21).

6. A wiper arm according to Claim 3, characterised in that the resilient positioning and retaining means comprise two lateral, resilient anchoring tongues (23) carried by the terminal portion (17) and a pair of lateral abutments (24) carried by the arm structure (2) and snap-engagable with the lateral tongues (23).

7. A wiper arm according to Claim 3, characterised in that resilient positioning and retaining means comprise a longitudinal resilient tongue (26) carried by the terminal portion (17) and a lateral longitudinal abutment (28) carried by the arm structure (5) and snap-engagable with the longitudinal tongue (26).

8. A wiper arm according to any one of Claims 4 to 7, characterised in that the arm structure (2) and the terminal portion (17) are of moulded plastics material.

9. A wiper arm according to any one of Claims 4 to 8, characterised in that the terminal portion (17) is pivoted on a pivoting end element (5) of the arm structure (2) one end of which is integral with the retaining claws (7) corresponding to the distal end of the wiper blade (12) and in that there is pivoted an arcuate element (9) carrying at one end the retaining claws (11) corresponding to the proximal end of the wiper blade (12), as well as the said first abutment (15), and at the other end intermediate retaining claws (10).

FIG. 1

FIG. 2

FIG. 3

FIG. 4

FIG. 6

FIG. 5

FIG. 7

FIG. 9

FIG. 8

FIG. 10

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | FR-A-2 625 153 (PAUL JOURNEE) | 1-3,5,8 | B60S1/38 |
| Y | * the whole document * | 9 | |
| | --- | | |
| X | US-A-3 103 687 (GOLUB ET AL) | 1-4 | |
| A | * the whole document * | 6,9 | |
| | --- | | |
| Y | GB-A-775 964 (O'SHEI) | 9 | |
| | * figures 1,4 * | | |
| | * page 2, line 5 - line 24 * | | |
| | * page 2, line 2 - line 10 * | | |
| | --- | | |
| X | DE-U-8 713 171 (CHAMPION SPARK PLUG EUROPE) | 1 | |
| A | * abstract; claims; figures * | 6,8 | |
| | * page 3, line 36 - page 4, line 28 * | | |
| | * page 5, line 13 - page 7, line 23 * | | |
| | --- | | |
| X | EP-A-0 285 379 (TRICO FOLBERTH) | 1 | |
| A | * abstract; claims 1,6; figures 1,5,6 * | 7,8 | |
| | * column 1, line 29 - line 51 * | | |
| | * column 2, line 11 - line 24 * | | TECHNICAL FIELDS SEARCHED (Int. Cl.5) |
| | * column 3, line 5 - line 27 * | | |
| | --- | | |
| X,P | FR-A-2 653 083 (JOURNEE) | 1-5,8,9 | |
| | * the whole document * | | B60S |
| | ----- | | |

The present search report has been drawn up for all claims

| Place of search | Date of completion of the search | Examiner |
|---|---|---|
| THE HAGUE | 19 FEBRUARY 1992 | WESTLAND P.G. |

EPO FORM 1503 03.82 (P0401)